# DEMANDE DE BREVET EUROPEEN

(11) **EP 3 675 613 A1**
(43) Date de publication de la demande: **01.07.2020**
(21) Numéro de dépôt: 19219735.8
(22) Date de dépôt: 26.12.2019
(51) Int. Cl.: H05K 7/14

(54) **ARMOIRE INFORMATIQUE MODULAIRE AVEC INTERCONNEXION EN CUIVRE**

(30) Priorité: 27.12.2018 FR 1874230; 20.03.2019 FR 1902873
(71) Demandeur: Bull SAS, 78340 Les Clayes-sous-Bois (FR)
(72) Inventeur: DEMANGE, Fabien, 78300 Poissy (FR); MAGNOUX, Sébastien, 95540 Mery-sur-Oise (FR)
(74) Mandataire: Cabinet Camus Lebkiri

(57) **Abrégé**

Armoire informatique modulaire avec interconnexion en cuivre configurée pour accueillir :
- Une pluralité de nœuds de calcul, les nœuds de calcul étant répartis dans une pluralité de lame de calcul, chaque nœud de calcul comportant un connecteur réseau ;
- Une pluralité de commutateurs réseau comportant une pluralité de connecteurs réseau ;
- Au moins un élément de distribution d'alimentation électrique ;
- Au moins un élément de refroidissement ;
les nœuds de calcul, les commutateurs réseau, l'élément de distribution d'alimentation électrique et l'élément de refroidissement étant mis en place sur au moins un bâti de l'armoire informatique, la mise en place et l'exploitation de ces éléments se faisant par une face avant et/ou par une face arrière de l'armoire. Ladite armoire est telle qu'au moins une paroi latérale de l'armoire comporte au moins une ouverture pour le passage d'au moins un câble d'interconnexion entre au moins un connecteur réseau d'un élément de l'armoire informatique et un connecteur réseau d'un élément d'une deuxième armoire informatique.

## Description

### Domaine technique

L'invention a pour objet une armoire informatique modulaire avec interconnexion en cuivre.

De domaine de l'invention est celui des armoires informatiques configurer pour contenir au moins de lames de calcul c'est-à-dire des éléments de calcul ayant un format dit « rackable » ou encore montable en bâti. Il s'agit d'un facteur de forme utilisé dans le domaine des calculateurs hautes performances. Les éléments utilisés ont des dimensions compatibles avec celles du bâti pour permettre leur fixation.

Le domaine de l'invention est encore celui des calculateurs hautes performances.

Le domaine de l'invention est encore celui des centres de calculs et des centres de données et plus particulièrement celui de l'installation d'armoires informatiques dans ces centres.

### Technique antérieure

Dans l'état de la technique on connaît des installations de dispositifs de calcul haute performance comportant plusieurs armoires informatiques. Cette pluralité d'armoire informatique est due à deux raisons :
- Le nombre de nœuds de calculs est trop important pour pouvoir être installé dans une seule armoire informatique ; et/ou
- L'architecture est telle que les armoires informatiques sont spécialisées, au moins une armoire informatique comporte des nœuds de calcul, au moins une autre armoire informatique comporte des commutateurs réseau.

Pour que le dispositif de calcul haute performance soit opérationnel, il faut que les nœuds de calcul puissent communiquer les uns avec les autres et donc il faut que :
- Les nœuds de calcul soient connectés à des commutateurs réseau ;
- Les commutateurs réseau soit connectés les uns avec les autres.

Le nombre de connexion varient en fonction d'une topologie réseau choisie. Parmi les topologies connues on cite au moins : fat tree bloquant, fat tree non bloquant,, tore 3d, hypercube. Cette liste n'est pas limitative.

Quelque soit la topologie il faut établir des connexions physiques inter-armoires entre au moins un élément, généralement un commutateur réseau, d'une armoire et un élément, généralement un commutateur réseau, d'une autre armoire.

Ces connexions physiques sont réalisées par des câbles dont la longueur est supérieure à 2 m. Cela pose des problèmes aux fréquences de fonctionnement des calculateur haute performance. En effet, dans ces calculateurs, les nœuds devraient pouvoir communiquer à des fréquences au moins égales à 20 Gb par seconde. Cependant, à ces fréquences, les câbles de cuivre d'une longueur supérieure à 2 m dégradent le signal ce qui réduit les performances du calculateur.

Pour surmonter ce problème, la solution de l'état de la technique est d'utilisé des câbles en fibre optique. Cela résout les problèmes de performance mais c'est câbles présentent au moins les inconvénients suivants :
- Ils sont sensiblement plus cher que des câbles de même longueur en cuivre ;
- Ils sont plus complexes, du fait des convertisseur optoélectroniques, et plus fragile qui diminue la fiabilité du calculateur.

### Résumé de l'invention

L'invention résout ces problèmes en proposant des chemins de câbles plus court et donc en rendant possible l'utilisation de câble de cuivre pour plus d'interconnexion, voir toutes les interconnexions. Dans l'inventions les câbles d'interconnexion inter-armoires passent par des ouvertures ménagées dans les parois latérales des armoires informatique. Ces câbles n'ont alors pas besoin de contourner la structure de l'armoire et sont plus courts.

L'invention a donc pour objet une armoire informatique modulaire configurée pour accueillir :
- Une pluralité de nœuds de calcul, les nœuds de calcul étant répartis dans une pluralité de lame de calcul, chaque nœud de calcul comportant un connecteur réseau ;
- Une pluralité de commutateurs réseau comportant une pluralité de connecteurs réseau ;
- Au moins un élément de distribution d'alimentation électrique ;
- Au moins un élément de refroidissement.

Les nœuds de calcul, les commutateurs réseau, l'élément de distribution d'alimentation électrique et l'élément de refroidissement sont mis en place sur au moins un bâti de l'armoire informatique, la mise en place et l'exploitation de ces éléments se faisant par une face avant et/ou par une face arrière de l'armoire, caractérisé en ce que au moins une paroi latérale de l'armoire comporte au moins une ouverture pour le passage d'au moins un câble d'interconnexion entre au moins un connecteur réseau d'un élément de l'armoire informatique et un connecteur réseau d'un élément d'une deuxième armoire informatique.

Outre les caractéristiques principales qui viennent d'être mentionnées dans le paragraphe précédent, le dispositif selon l'invention peut présenter une ou plusieurs caractéristiques complémentaires parmi les suivantes, considérées individuellement ou selon les combinaisons techniquement possibles c'est-à-dire :

L'ouverture est située en vis-à-vis des connecteurs réseau des commutateurs de l'armoire informatique.

Le câble d'interconnexion est court.

Le câble d'interconnexion est un câble QSFP.

L'ouverture à une hauteur comprise dans l'intervalle [150 mm, 280 mm] et une largeur comprise dans l'intervalle [130 mm, 170 mm].

Le bas de l'ouverture est situé à au moins 1 m du bas de l'armoire.

L'ouverture est située à au moins 100 mm du bord de l'armoire.

L'ouverture est équipée d'un joint de compatibilité électromagnétique pour assurer le confinement des signaux électromagnétiques

### Brève description des dessins

D'autres caractéristiques et avantages de l'invention ressortiront clairement de la description qui en est donnée ci-dessous, à titre indicatif et nullement limitatif, en référence aux figures annexées, parmi lesquelles :
[Fig 1] Une vue de face d'une armoire informatique selon l'invention.
[Fig 2] Une vue latérale d'une armoire informatique selon l'invention avec une visualisation par transparence d'éléments internes.
[Fig 3] Une vue partielle arrière au niveau de zone de commutation, en coupe longitudinale, de deux armoires informatiques selon l'invention.
[Fig 4] Une vue partielle arrière au niveau de zone de commutation, en coupe longitudinale, de trois armoires informatiques selon l'invention

### Description détaillée

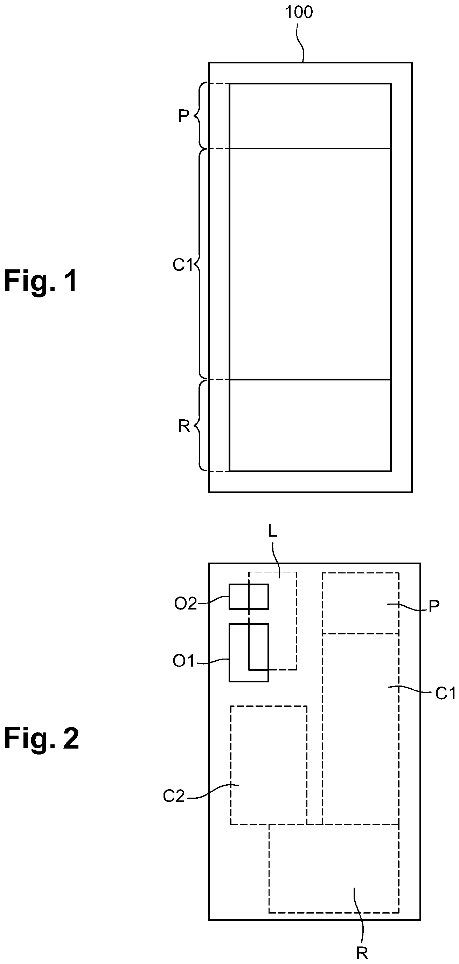

La figure 1 montre une vue avant d'une armoire 100 informatique selon l'invention. La figure 1 montre une armoire informatique vue de devant. Typiquement une armoire informatique à une capacité d'accueil d'une quarantaine de U. On rappel qu'un U mesure 1.75 pouces c'est-à-dire 44.45 mm.

Une armoire informatique comporte un bâti. Un bâti d'armoire informatique est une structure configurée pour accueillir des éléments dit « rackable » ou montable sur bâti. Chaque élément à un facteur de forme compatible avec le bâti et notamment une épaisseur qui s'exprime en multiple de U. Le bâti n'est pas représenté. Dans la pratique il est constitué des éléments de l'armoire en contact physique avec les éléments accueillis par l'armoire informatique. Ce bâti permet la fixation de ces éléments.

La figure 1 montre que l'armoire informatique comporte, en face avant, et en partant du bas de l'armoire :
- Une zone R de refroidissement d'une hauteur de 10.5 U ;
- Une première zone C1 de calcul avant d'une hauteur de 20 U. Cette zone peut donc accueillir 20 lames de calcul ;
- Une zone P de puissance d'une hauteur de 9 U.

La figure 2 montre une vue de coté de l'armoire informatique avec une visualisation par transparence des éléments intérieurs. Une armoire informatique a une profondeur utile qui correspond à une zone interne dans laquelle se situe un bâti sur lequel on peut accueillir les différents éléments de refroidissement, d'alimentation, de calcul et de commutation.

La figure 2 montre que :
- La zone R de refroidissement s'étend sur sensiblement deux tiers de la profondeur utile de l'armoire 100 informatique ;
- La première zone C1 de calcul s'entend sur sensiblement la moitié de la profondeur utile de l'armoire 100 informatique ;
- La zone P de puissance s'étend au-dessus de la première zone C1 de calcul.

La figure 2 montre également que l'armoire informatique comporte une deuxième zone C2 de calcul situé au-dessus de la zone R de refroidissement. La zone C2 de calcul a, par exemple une Hauteur de 12 U. La deuxième zone de calcul est située derrière la première zone de calcul. La deuxième zone de calcul est accessible par la face arrière de l'armoire informatique.

Une lame de calcul est accueillie en aveugle, dans une zone de calcul, grâce à l'utilisation de connecteur de fond de panier permettant des connexions en aveugle, par exemple les connecteurs de la gamme « STRADA Whisper ».

Une lame de calcul comporte un ou plusieurs nœuds de calcul. Chaque nœud de calcul est fonctionnellement un ordinateur et comporte donc au moins un microprocesseur, de la mémoire de stockage, de la mémoire de travail et au moins une interface de communication. Dans la pratique cette interface de communication est une interface réseau. Etant donnée les niveaux de performance cette interface réseau est au format QSFP.

On entend par câble QSFP un câble comportant des connecteurs compacts permettant une connexion à chaud et permettant des vitesses de communication d'au moins 20 gigabits par seconde.

La figure 2 montre une zone L de commutation situé au-dessus de la zone R de refroidissement et derrière la première zone C1 de calcul. La zone L de commutation a, par exemple, une hauteur de 12 U. La zone L de commutation peut donc accueillir 12 commutateurs réseau au format 1U.

Des profondeurs typiques pour les éléments cités sont :
- 540 mm pour des lames de calcul ;
- 250 mm pour un commutateur.

La zone L de commutation est située avec un retrait typique de 240mm par rapport à la face arrière de l'armoire informatique de manière à permettre l'utilisation des connecteurs que comporte les commutateurs accueillis par la zone L de commutation. La zone L de commutation est également située au-dessus des la deuxième zone C2 de calcul de manière à permettre une résorption de câble d'interconnexion entre la zone L de commutation et la deuxième zone C2 de calcul.

Il existe, entre la zone C2 de calcul et la zone L de commutation un espace appelé zone de résorption. Cet espace sert :
- à stocker le surplus de longueur de câble par exemple lorsque l'on utilise un câble de 2m pour une distance de 1m entre les connecteurs
- de zone de passage pour les câble inter-rack passant par les ouvertures latérales.

On entend par câble d'interconnexion un câble court, c'est-à-dire un câble de moins de deux mètres. Un tel câble est un câble en cuivre avec des connecteurs QSFP.

La figure 2 montre, sur la paroi latérale de l'armoire informatique, une première ouverture O1 situé en retrait de la face arrière et au niveau de la zone L de commutation. Le retrait est d'au moins 100mm. Ce retrait permet de maintenir la rigidité de l'armoire tout en permettant d'avoir une ouverture en vis-à-vis de connecteur d'un commutateur réseau accueilli dans la zone L de commutation.

La première ouverture O1 a des dimensions telle que sa hauteur est comprise dans l'intervalle [150 mm, 280 mm] et sa largeur est comprise dans l'intervalle [130 mm, 170 mm].

Les dimensions et la position de la première ouverture O1 sont telles qu'elles n'affaiblissent pas la structure de l'armoire tout en permettant le passage de câble d'interconnexion pour l'établissement de connexions inter-armoires. Une connexion inter-armoires est, par exemple, une connexion entre un commutateur réseau de l'armoire informatique, dite première armoire informatique, et un commutateur réseau d'une deuxième armoire informatique similaire à la première armoire informatique. Par similaire on entend une armoire qui comporte elle aussi une première ouverture telle que la première ouverture de la première armoire. La première ouverture de la première armoire est en vis-à-vis de la première ouverture de la deuxième armoire. Le chemin de câble est ainsi réduit. Cette réduction rend l'utilisation de câble en cuivre possible.

La figure 2 montre que la paroi latérale l'armoire informatique comporte une deuxième ouverture O2 située au-dessus de la première ouverture. La distance minimale entre les deux ouvertures est telle que ces ouvertures n'affaiblissent pas la structure de l'armoire relativement aux poids des éléments que l'armoire informatique doit contenir. Cette distance est au minimum de 100 mm. Le fait de prévoir plusieurs ouvertures permet de faire passer un plus grand nombre de câbles tout conservant une bonne résistance structurelle.

Dans une variante de l'invention les ouvertures sont équipées de joint d'étanchéité électromagnétique. Ces joints permettent d'assurer la continuité du blindage électromagnétique procuré par les armoires. Ce blindage est constitué par les parois de l'armoire, des portes de l'armoire est un tunnel formé par des joints électromagnétique de deux armoires voisines.

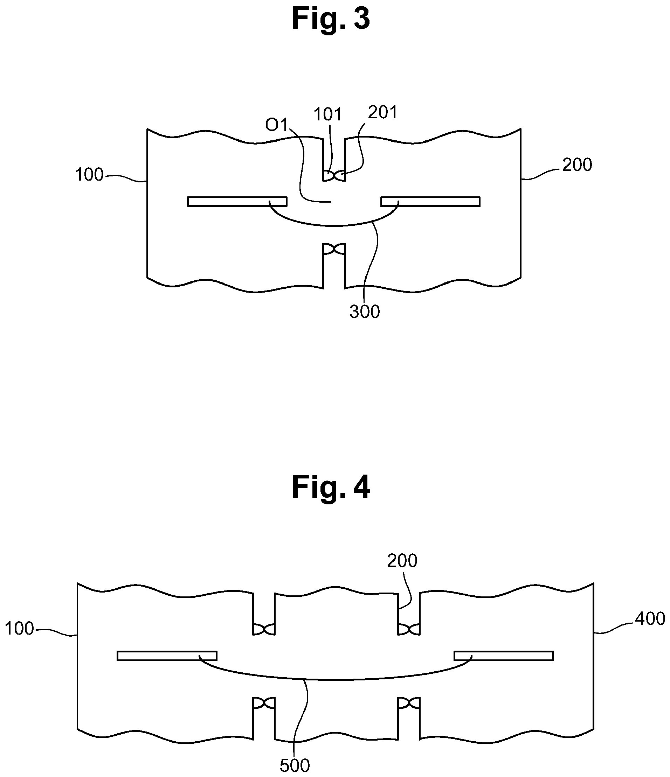

La figure 3 montre le joint 101 électromagnétique de la première armoire 100 informatique en contact physique avec un joint 201 d'une deuxième armoire 200 informatique. Le rayonnement électromagnétique des éléments contenus par les deux armoires est donc contenu même s'il peut passer d'une armoire à l'autre.

La figure 3 montre :
- Un premier commutateur réseau situé dans la première armoire réseau ;
- Un deuxième commutateur réseau situé dans la deuxième armoire réseau
- Un câble 300 d'interconnexion connecté au premier commutateur réseau au deuxième commutateur réseau à travers les ouvertures des armoires informatiques.

Dans une variante l'armoire a des ouvertures d'interconnexion sur chacune de ses parois latérales. Une ouverture d'interconnexion non utilisée est fermée par un couvercle garantissant l'étanchéité électromagnétique de l'armoire informatique.

La figure 4 montre :
- Un troisième commutateur réseau situé dans une troisième armoire réseau situé à coté de la deuxième armoire réseau mais de l'autre coté par rapport à la première armoire réseau.
- Un câble 500 d'interconnexion connecté au premier commutateur réseau au troisième commutateur réseau à travers les ouvertures des armoires informatiques. Au niveau de la deuxième armoire ce câble 500 passe par la zone de résorption, ou par la zone L si elle n'est pas complètement remplie par des commutateurs.

Une armoire informatique contient des lames de calcul qui ont une largeur de 600 mm. Une armoire informatique a donc une largeur de moins de 1000 mm. La configuration de la figure 4 est donc réalisable avec des câbles d'interconnexion de moins de deux mètres.

On voit que l'invention permet la mise en œuvre de configuration à trois armoires informatiques c'est-à-dire à (20 + 12) * 3 = 96 lames de calcul. C'est-à-dire une configuration à 288 nœuds de calcul connecté selon une topologie « fat tree », ou une autre, en n'utilisant que des câbles courts donc en cuivre.

Les ouvertures des armoires selon l'invention permettent donc des chemins de câbles plus courts que les armoires connus. En effet avec les armoires connus les câbles passent par le toit des armoires et doivent donc être plus longs.

On note que l'invention présente également un intérêt avec des configurations moins denses, c'est-à-dire avec moins d'armoires et/ou moins de lames de calcul par armoire, et/ou une topologie réseau demandant moins de câbles pour être réalisée. L'invention permet de globalement réduire les distances entre les commutateurs réseau des armoires informatiques.

## Revendications

1. Armoire informatique modulaire configurée pour accueillir :
- Une pluralité de nœuds de calcul, les nœuds de calcul étant répartis dans une pluralité de lame de calcul, chaque nœud de calcul comportant un connecteur réseau ;
- Une pluralité de commutateurs réseau comportant une pluralité de connecteurs réseau ;
- Au moins un élément de distribution d'alimentation électrique ;
- Au moins un élément de refroidissement ;
les nœuds de calcul, les commutateurs réseau, l'élément de distribution d'alimentation électrique et l'élément de refroidissement étant mis en place sur au moins un bâti de l'armoire informatique, la mise en place et l'exploitation de ces éléments se faisant par une face avant et/ou par une face arrière de l'armoire, **caractérisé en ce que** au moins une paroi latérale de l'armoire comporte au moins une ouverture pour le passage d'au moins un câble d'interconnexion entre au moins un connecteur réseau d'un élément de l'armoire informatique et un connecteur réseau d'un élément d'une deuxième armoire informatique.

2. Armoire informatique selon la revendication précédente, **caractérisé en ce que** l'ouverture est située en vis-à-vis des connecteurs réseau des commutateurs de l'armoire informatique.

3. Armoire informatique selon l'une des revendications précédentes, **caractérisée en ce que** le câble d'interconnexion est court.

4. Armoire informatique selon l'une des revendications précédentes, **caractérisée en ce que** le câble d'interconnexion est un câble QSFP.

5. Armoire informatique selon l'une des revendications précédentes, **caractérisée en ce que** la au moins une ouverture à une hauteur comprise dans l'intervalle [150 mm, 280 mm] et une largeur comprise dans l'intervalle [130 mm, 170 mm].

6. Armoire informatique selon l'une des revendications précédentes, **caractérisé en ce que** le bas de la au moins une ouverture est situé à au moins 1 m du bas de l'armoire.

7. Armoire informatique selon l'une des revendications précédentes, **caractérisé en ce que** la au moins une ouverture est située à au moins 100 mm du bord de l'armoire.

8. Armoire informatique selon l'une des revendications précédentes, **caractérisé en ce que** la distance minimale entre deux ouvertures d'une même paroi de l'armoire est de 100 mm.

9. Armoire informatique selon l'une des revendications précédentes, **caractérisé en ce que** la au moins une ouverture est équipée d'un joint de compatibilité électromagnétique pour assurer le confinement des signaux électromagnétiques.
